# EUROPEAN PATENT SPECIFICATION

(11) **EP 0 516 398 B1**
(45) Date of publication and mention of the grant of the patent: **24.09.1997**
(21) Application number: 92304804.5
(22) Date of filing: 27.05.1992
(51) Int. Cl.: H05B 33/08, H01S 3/133

(54) **Method and apparatus for controlling the emission spectrum of a light emitting diode**
Methode und Apparat zur Steuerung des Emissionsspektrums einer Elektrolumineszensdiode
Méthode et appareil pour contrôler le spectre d'émission d'une diode électroluminescente

(30) Priority: 27.05.1991 JP 121317/91
(43) Date of publication of application: 02.12.1992
(73) Proprietor: Mitsubishi Chemical Corporation, Chiyoda-ku Tokyo (JP)
(72) Inventor: Noguchi, Masahiro, Tsuchiura-city, Ibaraki-prefecture (JP)
(74) Representative: Bubb, Antony John Allen

(56) References cited:
- EP-A- 0 292 957
- WO-A-87/01875
- GB-A- 2 224 374
- US-A- 4 710 631
- US-A- 5 018 154

## Description

This invention relates to a method and apparatus for controlling the emission spectrum of a light emitting diode, and more especially to a method and apparatus which is able to control the emission spectrum of a light emitting diode (LED) with high precision to enable the latter to be utilized for an emission element of a standard light source, as an LED light source for a sensor, in optical communication equipment, and the like.

It is known that the emission spectrum of an LED changes with ambient temperature or with the driving current. In order to take account of this, when an LED standard light source which emits light of a specific spectral wavelength is manufactured, the LED is, for example, set in a thermostatic chamber and the temperature of the LED is controlled to a specified value while monitoring the emission spectrum.

Examples of means of controlling a temperature of a LED or other light emitting semiconductor device are described for example in GB -A - 2 224 374 and WO - A - 87 01 875. Such devices involve relatively complicated provisions for temperature measurement and/or control and thus have disadvantages either because of lack of precision of control or unnecessarily complicated control arrangements.

There has further been proposed - see US - A - 5 018 154 an arrangement for stabilising the optical output of a semiconductor laser wherein the temperature of a semiconductor laser is measured directly and the measured temperature is used to derive a correction coefficient from a compensation circuit in order that the operating parameters of the semiconductor device can be controlled to compensate for optical output error caused by temperature change. However, such an arrangement does not provide for control of the emission wavelength of the laser and requires additional measuring elements including means for sensing the optical output of the laser.

In order to control the emission spectrum quantitatively and precisely by monitoring the emission spectrum itself, a spectrometer is needed that is bulky and expensive. The system as a whole thus becomes expensive and is also inconvenient to carry about and difficult to handle.

It is an object of the invention to solve the above-mentioned problem, and to provide an emission spectrum control apparatus which is simple, is of small size and easy to handle. Also the manufacturing cost of the system should be reduced by making possible mass production using integrated circuitry.

The invention accordingly provides a method for controlling the emission wavelength of a light emitting diode (LED), characterised in that it comprises the steps of measuring the ambient temperature of the LED, measuring the energising power applied to the LED, calculating the emission wavelength from the measured values of temperature and applied power and from known characteristics of the LED, determining the difference between the calculated emission wavelength and a desired emission wavelength and controlling the power applied to the LED in a sense such as to reduce said difference.

The invention further provides an apparatus for controlling the emission spectrum of a light emitting diode, and including means for energising a light emitting diode (LED), characterised in that it comprises means for measuring the power applied to said LED by said energising means, means for measuring the temperature of said LED, means for controlling the power applied to said LED and means for calculating the emission wavelength of the LED from said measured values and for operating said control means to vary the power applied to said LED in accordance with a difference between said calculated value of the emission wavelength and a desired value.

Further preferred features and advantages of the invention will become apparent from the following description, read in conjunction with the claims.

The invention is illustrated by way of example in the accompanying drawings, in which :
Fig. 1 is a block circuit diagram of one embodiment of apparatus according to the invention,
Fig. 2 is a side elevation of one example of an LED for use in an apparatus according to the invention,

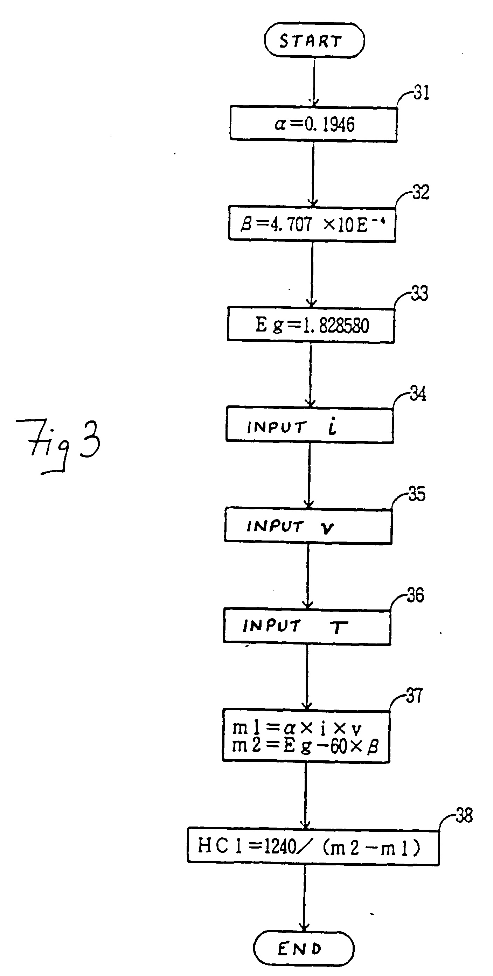

Fig. 3 is a flow chart illustrating steps in the calculation of the emission wavelength of an LED, and
Fig. 4 is a flow chart illustrating steps in the control of the emission wavelength of an LED.

First, the principle for controlling an LED emission spectrum according to the present invention will be explained.

The emission wavelength energy is expressed by the following equation:$\text{(Emission wavelength energy) = (Optical bandgap at a}$$\text{standard temperature) - α x (Applied power) - β x (Difference from a standard temperature)}$

The standard temperature in equation (1) can be an arbitrary temperature decided beforehand, and the coefficients, α and β are values obtained experimentally based on characteristics of the LED such as its material, its shape, etc. The optical bandgap of a material is decreased by the heat generated by the driving power or a rise in ambient temperature. Since the wavelength energy (the reciprocal of emission wavelength) is dependent upon the optical bandgap, once the values of the coefficients α and β have been found experimentally, the emission wavelength can be obtained from equation (1). The emission wavelength spectrum can then be controlled by controlling the corresponding driving power of the LED.

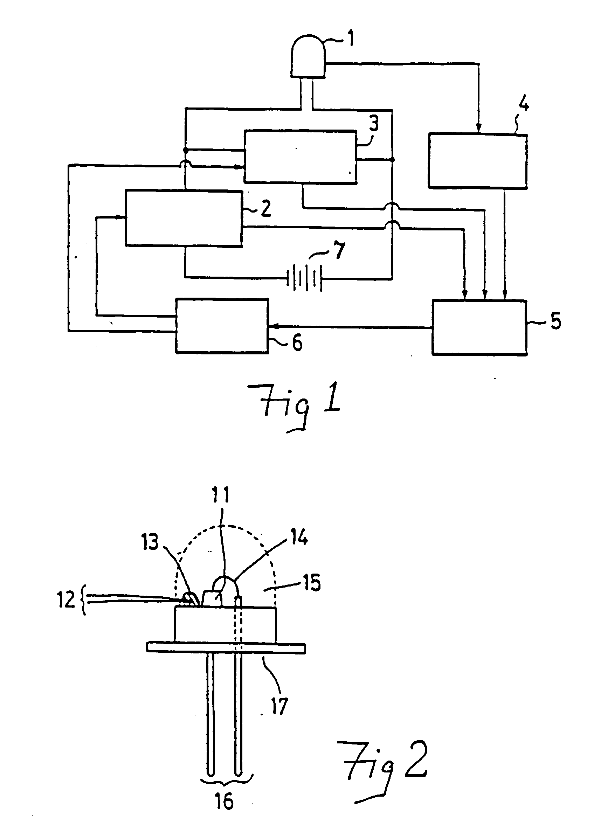

Referring to Fig.1, the reference numeral 1 indicates an LED with an associated temperature sensor, not shown. The LED 1 is coupled to a power source indicated diagrammatically at 7 via a circuit 2 for measuring and controlling the current drawn by the LED 1 and a circuit 3 for measuring and controlling the voltage applied to the LED 1. An input of a temperature measuring circuit 4 is coupled to an output of the said sensor, and an output of the temperature measuring circuit 4 is coupled to an input of a computing unit 5. Further inputs of the computing unit 5 are coupled to measurement outputs of the circuits 2 and 3, and an output of the computing unit 5 is coupled to an input of a circuit 6 for controlling the emission wavelength of the LED, the latter circuit having outputs coupled to control inputs of the circuits 2 and 3.

In this case, the temperature to be measured by the sensor referred to is not limited to the temperature of the LED itself, and the temperature of the environment in which the LED is disposed can be measured. The sensor can be either a contact type or a noncontact type, and the desirable range in which a sensor may be disposed is within a radius of 300 mm from a radiating LED in the case of a contact type sensor, and within 15 mm in the case of a noncontact type sensor. More than one LED or more than one sensor can be provided if desired; in this case, provided that the shortest distance among the combinations of positions of sensors and positions of LED's is within the range of 300 mm or 15 mm, the arrangement can be considered to be satisfactory. A thermocouple or a platinum resistor can be used as a contact type sensor, an an infrared ray detector or a thermopile can be used as a noncontact type sensor.

Fig. 2 shows an embodiment of an LED lamp provided with a sensor for temperature measurement. An LED 11 is bonded to a TO-18 can type header 17, a C-A thermocouple 12 is fixed in place with an epoxy adhesive 13 such as Araldite (Registered Trade Mark), the LED and a terminal pin 16 are connected with an Au wire 14, and the above-mentioned arrangement is encapsulated in a transparent coating resin 15.

When the arrangement described above is incorporated in the circuit of Fig 1 the operation of the system is as follows: A temperature signal detected by the thermocouple 12 is converted to a digital signal by the temperature measuring circuit 4, which includes a voltmeter and an A/D converter, and the temperature information is input to the computing unit 5. On the other hand, values of the voltage and current applied to the LED 11 are input to the computing unit 5 from the measurement and control circuit 2, and the measurement and control circuit 3. In the computing unit 5, a calculating operation is performed utilising the above-mentioned equation (1), as described in more detail below, to determine the present emission wavelength of the LED 11. From the calculated result, the difference between the calculated wavelength and a desired wavelength is determined in the emission wavelength control means 6, and the emission wavelength is controlled in accordance with the equation (1), as also described below, via the current measurement and control circuit 2 and/or the voltage measurement and control circuit 3. The power control for the LED can be performed by controlling current or voltage individually or both of them simultaneously. Thus a desired emission wavelength spectrum can be obtained from the LED.

The above mentioned emission wavelength calculation will now be explained. As shown in Fig, 3, the following data values are derived from stored data characteristics of the LED: the coefficient α is 0.1946; the coefficient β is 4.707 x 10⁻⁴ and the optical gap, Eg, at a standard temperature is 1.828580 eV (steps 31 to 33). Then, measured values of 0.03 A, 1.86 V and 60° C are substituted for current, i, voltage, v, and temperature, T, respectively (steps 34 to 36). The value ml = α x i x v, and the value m2 = Eg - 60 x β are found (step 37), and the present emission wavelength HCI is obtained from the formula 1240/(m2-m1) (step 38). The value (m2-m1) corresponds to the right side of the equeation (1), and its reciprocal is the emission wavelength. The number 1240 in step 38 is a constant.

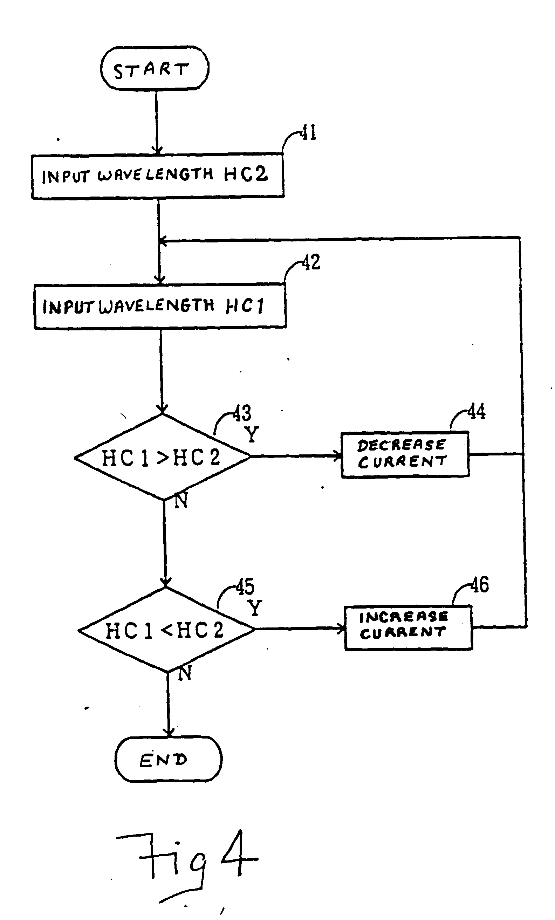

In the emission wavelength control process, as shown in Fig. 4, first, a desired wavelength HC2 is input and then the present emission wavelength HC1 derived from the above calculation is input (step 41 and 42). Next, the values HC1 and HC2 are compared, and if HC1 is larger, the power applied to the LED 11 is decreased, whereas if HC1 is smaller, the power is increased. The above processes are continuously repeated and thus the emission wavelength can be maintained at the desired value HC2.

A simple explanation of the coefficients α and β will be given in the following examples.
1. At 273 K,
   when i = 10 mA, v= 1.720 V and the central frequencey, HC, = 679.2 nm, are detected, and when i = 20 mA, v = 1.825 V and the central frequencey, HC, = 680.6 nm are detected, and these data are substituted in equation (1) the value α = 0.1945336-- is obtained.
2. At 293 K
   when i = 10 mA, v = 1.690 v and the central frequency, HC, = 682.7 nm are detected, and when i = 20 mA, v = 1.800 V and the central frequency, HC, = 684.1 nm are detected, and these data are substituted in equation (1) the value α = 0.1945654--- is obtained. Therefore, it is understood that α is a constant independent of temperature and the value is approximately 0.2. When the equation (1) is solved for β giving the conditions, 1 and 2, described in the above, β=4.707 x 10⁻⁴ is obtained.

In equation (1), when the standard temperature, Td, = 273K, Eg = 1.828580, the temperature, Ti, = 333 K (60° C), and the current i flowing the LED = 30 mA, the voltage, v, = 1.86 V is obtained using the values, α = 0.2, and β = 4.707 x 10⁻⁴; when HC is obtained by an operation process using these data, the emission wavelength, HC, is found to be 692.888 nm. On the other hand, a measured value determined experimentally is 692.900nm. Thus the error (difference between the emission wavelength energy obtained by calculation and the measured value) is as little as 0.03 meV in the method according to the invention.

Therefore, as described above, the present invention makes it possible to control an emission wavelength extremely precisely simply by measuring the current, the voltage and the temperature of the LED, with a simple apparatus and without actually measuring the emission spectrum using an expensive apparatus such as a spectrometer. Thus, it is possible to provide an emission spectrum controlling apparatus of low cost which can be used for an LED standard light source, LED light sources for sensors, optical communication equipment and the like.

## Claims

1. A method for controlling the emission wavelength of a light emitting diode (LED) (1), characterised in that it comprises the steps of measuring the ambient temperature (4) of the LED, measuring the energising power applied to the LED, calculating the emission wavelength from the measured values of temperature and applied power and from known characteristics of the LED, determining the difference between the calculated emission wavelength and a desired emission wavelength and controlling (6) the power applied to the LED (1) in a sense such as to reduce said difference.

2. A method according to Claim 1, characterised in that the temperature of the LED is measured by means of a sensor in thermal contact with said LED and within a radius of 300 mm thereof.

3. A method according to Claim 1, characterised in that the temperature of the LED is measured by a sensor responsive to radiant heat and located out of contact with said LED within a radius of 15 mm thereof.

4. A method according to any one of claims 1-3, wherein the power applied to said LED is measured by measuring separately the voltage applied thereto and the current drawn thereby.

5. A method according to any one of claims 1-4, wherein the emission wavelength is calculated from the formula$\text{(Emission wavelength energy) = (optical bandgap at a standard temperature) - α x (Applied power) - β x (Difference from a standard temperature).}$ wherein α and β are coefficients determined experimentally for the LED concerned.

6. An apparatus for controlling the emission spectrum of a light emitting diode, and including means (2,3) for energising a light emitting diode (LED) (1,11), characterised in that it comprises, means (2,3) for measuring the power applied to said LED by said energising means (2,3), means (12,4) for measuring the temperature of said LED, means (6) for controlling the power applied to said LED and means (5) for calculating the emission wavelength of the LED from said measured values and for operating said control means (6) to vary the power applied to said LED in accordance with a difference between said calculated value of the emission wavelength and a desired value.

7. An apparatus according to Claim 6, characterised in that said means for measuring the temperature of the LED (11) comprises a thermocouple (13) in thermal contact with the LED (11) and a measuring circuit (4) responsive to the output of the thermocouple.

8. An apparatus according to claim 6 or 7, characterised in that said means (5) for calculating the emission wavelength comprises a data processor programmed to derive the emission wavelength from values provided by said measuring means (2,3,4) and from stored data values relating to said LED.

9. An apparatus according to any one of claims 6-8, characterised in that said means for measuring the applied power comprise separate means (2,3) for measuring respectively current and voltage applied to said LED.

10. An apparatus according to any one of claims 6-9, characterised in that said means (6) for controlling the power applied to said LED is arranged to control the current and/or the voltage applied to said LED.

## Patentansprüche

1. Verfahren zur Steuerung der Emissionswellenlänge einer lichtemittierenden Diode (LED) (1), gekennzeichnet durch die Schritte: Messen der Umgebungstemperatur (4) der LED, Messen der der LED zugeführten Erregungsleistung, Berechnen der Emissionswellenlänge aus den gemessenen Werten von Temperatur und zugeführter Leistung und aus bekannten Kennwerten der LED, Bestimmen der Differenz zwischen der berechneten Emissionswellenlänge und einer gewünschten Emissionswellenlänge und Steuern (6) der der LED (1) zugeführten Leistung, um diese Differenz zu reduzieren.

2. Verfahren nach Anspruch 1, dadurch gekennzeichnet, daß die Temperatur der LED mittels eines Sensors in thermischem Kontakt mit der LED und bezüglich dieser innerhalb eines Radius von 300 mm gemessen wird.

3. Verfahren nach Anspruch 1, dadurch gekennzeichnet, daß die Temperatur der LED mittels eines Sensors gemessen wird, der auf Strahlungswärme anspricht und außer Kontakt mit der LED innerhalb eines Radius von 15 mm bezüglich dieser angeordnet ist.

4. Verfahren nach einem der Ansprüche 1 bis 3, bei dem die der LED zugeführte Leistung gemessen wird, indem getrennt die an dieser anliegende Spannung und der von dieser aufgenommene Strom gemessen wird.

5. Verfahren nach einem der Ansprüche 1 bis 4, bei dem die Emissionswellenlänge aus der Formel berechnet wird:$\text{(Emissionswellenlängenenergie) = (optischer Bandabstand bei einer Standardtemperatur) - α x (zugeführte Leistung) - ß x (Abweichung von einer Standardtemperatur),}$ wobei α und β Koeffizienten sind, die experimentell für die betreffende LED bestimmt werden.

6. Vorrichtung zur Steuerung des Emmissionsspektrums einer lichtemittierenden Diode, mit einer Einrichtung (2, 3) zum Speisen einer lichtemittierenden Diode (LED) (1, 11), gekennzeichnet durch eine Einrichtung (2, 3) zum Messen der durch die Einrichtung (2, 3) zum Speisen der LED zugeführten Leistung, eine Einrichtung (12, 4) zum Messen der Temperatur der LED, eine Einrichtung (6) zur Steuerung der der LED zugeführten Leistung und eine Einrichtung (5) zum Berechnen der Emissionswellenlänge der LED aus den gemessenen Werten und zum Ansteuern der Steuerungseinrichtung (6), um die der LED zugeführte Leistung entsprechend einer Differenz zwischen dem berechneten Wert der Emissionswellenlänge und einem gewünschten Wert zu verändern.

7. Vorrichtung nach Anspruch 6, dadurch gekennzeichnet, daß die Einrichtung zum Messen der Temperatur der LED (11) ein Thermoelement (13), das mit der LED (11) thermischen Kontakt hat, und einen Meßschaltkreis (4) enthält, der auf die Ausgabe des Thermoelementes anspricht.

8. Vorrichtung nach Anspruch 6 oder 7, dadurch gekennzeichnet, daß die Einrichtung (5) zum Berechnen der Emissionswellenlänge einen Datenprozessor enthält, der programmiert ist, um die Emissionswellenlänge aus Werten zu bestimmen, die von der Meßeinrichtung (2, 3, 4) und aus gespeicherten Datenwerten stammen, die die LED betreffen.

9. Vorrichtung nach einem der Ansprüche 6 bis 8, dadurch gekennzeichnet, daß die Einrichtung zum Messen der zugeführten Leistung getrennte Einrichtungen (2, 3) enthält, um jeweils den Strom und die Spannung zu messen, die der LED zugeführt werden.

10. Vorrichtung nach einem der Ansprüche 6 bis 9, dadurch gekennzeichnet, daß die Einrichtung (6) zur Steuerung der der LED zugeführten Leistung dazu ausgestaltet ist, um den Strom und/oder die Spannung zu steuern, die der LED zugeführt werden.

## Revendications

1. Procédé de régulation de la longueur d'onde d'émission d'une diode luminescente (LED) (1), caractérisé en ce qu'il comprend les étapes de mesure de la température ambiante (4) de la LED, mesure de la puissance d'excitation appliquée à la LED, calcul de la longueur d'onde d'émission à partir des valeurs mesurées de température et de puissance appliquée et à partir de caractéristiques connues de la LED, détermination de la différence entre la longueur d'onde d'émission calculée et une longueur d'onde d'émission souhaitée, et régulation (6) de la puissance appliquée à la LED (1) dans un sens propre à réduire ladite différence.

2. Procédé selon la Revendication 1, caractérisé en ce que la température de la LED est mesurée au moyen d'un capteur en contact thermique avec ladite LED et dans un rayon de 300 de celle-ci.

3. Procédé selon la Revendication 1, caractérisé en ce que la température de la LED est mesurée par un capteur réagissant à la chaleur rayonnante et situé hors de contact avec ladite LED dans un rayon de 15 mm de celle-ci.

4. Procédé selon l'une quelconque des revendications 1-3, dans lequel la puissance appliquée à ladite LED est mesurée par mesure séparée de la tension qui lui est appliquée et du courant consommé par elle.

5. Procédé selon l'une quelconque des revendications 1-4 dans lequel la longueur d'onde d'émission est calculée à partir de la formule$\text{(Energie de longueur d'onde d'émission) = (bande interdite optique à une température standard) - α x (Puissance appliquée) - β x (Ecart par rapport à une température standard).}$ où α et β sont des coefficients déterminés expérimentalement pour la LED concernée.

6. Appareil pour la régulation du spectre d'émission d'une diode luminescente, et comprenant un moyen (2,3) pour exciter une diode luminescente (LED) (1,11), caractérisé en ce qu'il comprend : un moyen (2,3) pour mesurer la puissance appliquée à ladite LED par ledit moyen d'excitation (2,3), un moyen (12,4) pour mesurer la température de ladite LED, un moyen (6) de régulation de la puissance appliquée à ladite LED et un moyen (5) pour calculer la longueur d'onde d'émission de la LED à partir desdites valeurs mesurées et pour commander ledit moyen de régulation (6) afin de faire varier la puissance appliquée à ladite LED conformément à une différence entre ladite valeur calculée de la longueur d'onde d'émission et une valeur souhaitée.

7. Appareil selon la Revendication 6, caractérisé en ce que ledit moyen pour mesurer la température de la LED (11) comprend un thermocouple (13) en contact thermique avec la LED (11) et un circuit de mesure (4) réagissant à la sortie du thermocouple.

8. Appareil selon la revendication 6 ou 7, caractérisé en ce que ledit moyen (5) pour calculer la longueur d'onde d'émission comprend un processeur de données programmé pour dériver la longueur d'onde d'émission des valeurs fournies par ledit moyen de mesure (2,3,4) et de valeurs de données mémorisées relatives à ladite LED.

9. Appareil selon l'une quelconque des revendications 6-8, caractérisé en ce que ledit moyen pour mesurer la puissance appliquée comprend des moyens séparés (2,3) pour mesurer respectivement le courant et la tension appliqués à ladite LED.

10. Appareil selon l'une quelconque des revendications 6-9, caractérisé en ce que ledite moyen (6) de régulation de la puissance appliquée à ladite LED est agencé pour assurer la régulation du courant et/ou de la tension appliqués à ladite LED.
